# EUROPÄISCHE PATENTSCHRIFT

(11) **EP 2 530 475 B1**
(45) Veröffentlichungstag und Bekanntmachung des Hinweises auf die Patenterteilung: **16.07.2014**
(21) Anmeldenummer: 12167772.8
(22) Anmeldetag: 11.05.2012
(51) Int. Cl.: G01R 15/20

(54) **Vorrichtung zur Messung eines durch ein elektrisches Kabel fliessenden Stroms**
Device for measuring a current flowing through a cable
Dispositif de mesure d'un courant électrique passant dans un câble électrique

(30) Priorität: 30.05.2011 CH 9182011; 26.08.2011 CH 13942011
(43) Veröffentlichungstag der Anmeldung: 05.12.2012
(73) Patentinhaber: Melexis Technologies NV, 3980 Tessenderlo (BE); maglab GmbH, 4056 Basel (CH)
(72) Erfinder: Racz, Robert, 6300 Zug (CH); Krummenacher, Peter, 4051 Basel (CH)
(74) Vertreter: Falk, Urs

(56) Entgegenhaltungen:
- US-A- 4 717 872
- US-A1- 2003 227 285
- US-A1- 2006 232 262
- US-B1- 6 426 617

## Beschreibung

Die Erfindung betrifft eine Vorrichtung zur Messung eines durch ein elektrisches Kabel fliessenden Stroms, also einen Stromsensor, wobei ein Magnetfeldsensor die Stärke des vom Strom erzeugten Magnetfelds misst.

Aus dem Stand der Technik sind eine Vielzahl von Stromsensoren bzw. Vorrichtungen zur Strommessung bekannt. EP 1811311 offenbart eine Vorrichtung zur Strommessung, die sich für die Messung von Strömen bis zu typischerweise 100A eignet, kurzzeitig mit einem Überlaststrom von bis zu 1000A belastbar ist und gegen äussere magnetische Störfelder abgeschirmt ist. CH 696859 und JP 62098267 offenbaren Stromsensoren, bei denen ein erster Hallsensor im Luftspalt eines Jochs aus ferromagnetischem Material angeordnet ist, das den Stromleiter umschliesst, und ein zweiter Hallsensor ausserhalb des Jochs angeordnet ist. Das Joch und der erste Hallsensor dienen zur Messung relativ kleiner Ströme, der zweite Hallsensor dient zur Messung relativ grosser Ströme. Nachteilig bei diesen letzteren Stromsensoren ist, dass der Luftspalt mit typischerweise 1-3 mm relativ gross ist, das Joch viel Material benötigt und die Herstellung und Montage aufwendig ist.

Aus der US 2003227285 ist ein Stromsensor bekannt, der einen aus übereinander liegenden Blechen gebildeten Kern mit einem Luftspalt umfasst. Der Kern ist im wesentlichen C-förmig. Die beiden einander gegenüberliegenden Enden des Kerns sind abgestuft und mit je einer Nut ausgebildet. Eine Leiterplatte mit einem darauf montierten Magnetfeldsensor ist einschnappbar in die einander gegenüberliegenden Nuten eingesetzt.

Aus der US 6426617 ist ein Stromsensor bekannt, der einen aus übereinander liegenden Blechen gebildeten Kern mit einem Luftspalt umfasst, in dem ein Hallsensor angeordnet ist. Der Kern ist im wesentlichen C-förmig. Der Kern ist mit Füssen ausgebildet, die in eine Leiterplatte gesteckt sind. Anschlussbeinchen des Hallsensors sind ebenfalls in die Leiterplatte gesteckt.

Aus der US 4717872 ist ein Stromsensor bekannt, der zwei separate Kerne aufweist, die beidseitig eines zweiadrigen Kabels angeordnet sind. Als Sensoren werden entweder Spulen, die um die Kerne gewickelt sind, oder Hallsensoren, die in Luftspalten der Kerne angeordnet sind, verwendet.

Aus der US 2006232262 ist ein Stromsensor bekannt, der einen C-förmigen Kern in verschiedenen Varianten und in einem oder mehreren Luftspalten des Kerns angeordnete Magnetfeldsensoren umfasst.

Der Erfindung liegt die Aufgabe zugrunde, einen Stromsensor für die Messung eines durch ein Kabel fliessenden Stroms zu entwickeln, der eine wirksame Abschirmung gegen äussere Störfelder bietet und auf einfache Weise montierbar ist.

Die genannte Aufgabe wird erfindungsgemäss gelöst durch die Merkmale des Anspruchs 1. Vorteilhafte Ausgestaltungen ergeben sich aus den abhängigen Ansprüchen.

Die Erfindung wird nachfolgend anhand von Ausführungsbeispielen und anhand der Zeichnung näher erläutert. Die Figuren sind nicht massstäblich gezeichnet.
- Fig. 1: zeigt ein erstes Ausführungsbeispiel einer erfindungsgemässen Vorrichtung zur Messung eines durch ein elektrisches Kabel fliessenden Stroms,
- Fig. 2: zeigt ein Stück Blech, das als Ausgangspunkt für ein ferromagnetisches Bauteil dient,
- Fig. 3 - 5: zeigen Magnetfeldsensoren,
- Fig. 6 - 11: zeigen Varianten des ersten Ausführungsbeispiels,
- Fig. 12: zeigt das erste Ausführungsbeispiel in perspektivischer Darstellung,
- Fig. 13, 14: zeigen in seitlicher Ansicht zwei Varianten des Ausführungsbeispiels der Fig. 12,
- Fig. 15: zeigt eine Vorrichtung zur Messung eines durch ein elektrisches Kabel fliessenden Stroms, und
- Fig. 16: zeigt eine Variante davon.

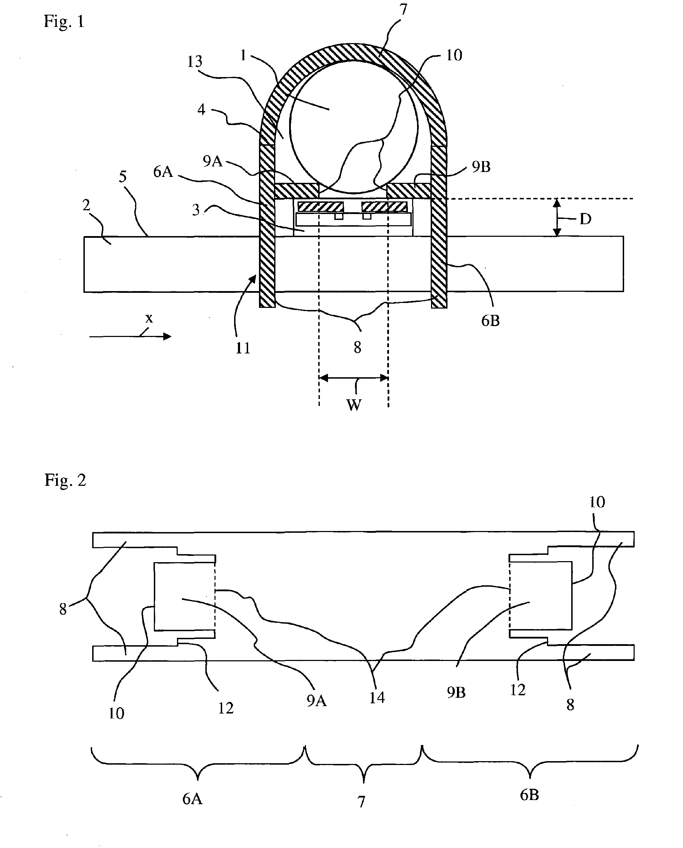

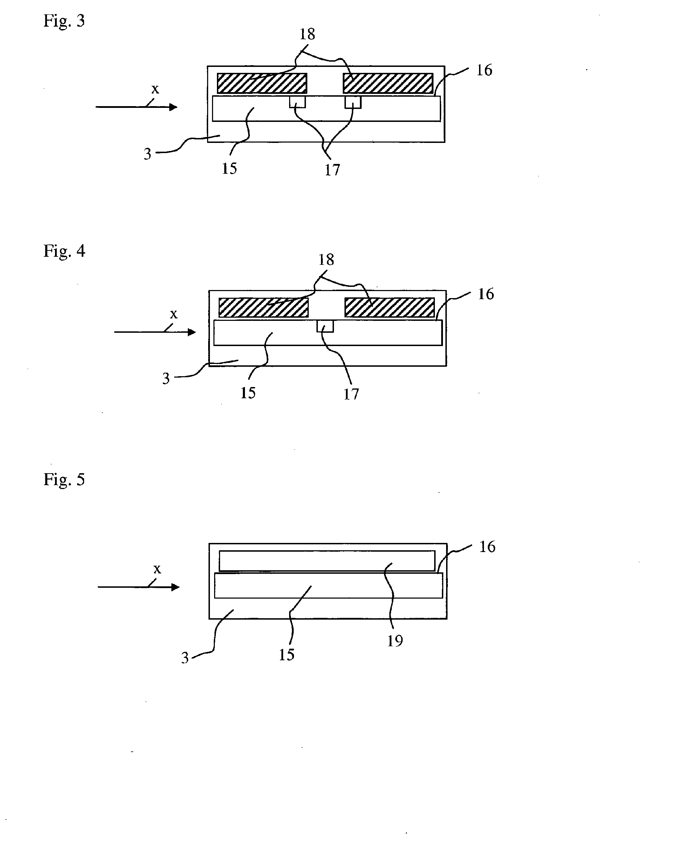

Die Fig. 1 zeigt im Schnitt ein erstes Ausführungsbeispiel einer erfindungsgemässen Vorrichtung zur Messung eines durch ein elektrisches Kabel 1 fliessenden Stroms. Der Querschnitt eines solchen Kabels 1 ist typischerweise kreisförmig. Die Vorrichtung umfasst eine Leiterplatte 2, einen Magnetfeldsensor 3 und ein ferromagnetisches Bauteil 4. Der in dieser Figur gezeigte Aufbau des Magnetfeldsensors 3 wird später anhand der Fig. 3 im Detail beschrieben. Der Magnetfeldsensor 3 ist auf einer Oberfläche 5 der Leiterplatte 2 angeordnet und empfindlich auf eine Komponente des Magnetfelds, die parallel zur Oberfläche 5 der Leiterplatte 2 verläuft. Die Richtung dieser Komponente ist in der Zeichnung als x-Richtung bezeichnet. Das ferromagnetische Bauteil 4 ist aus einem Stück Blech (siehe auch Fig. 2) gebildet, das U-förmig gebogen ist. Der Begriff "Blech" ist überall so zu verstehen, dass er auch ein Laminat aus übereinander angebrachten dünnen Blechen umfasst. Das U-förmig gebogene Bauteil 4 hat somit zwei gerade Schenkel 6A und 6B, die nahtlos in ein etwa halbkreisförmig gebogenes Mittelteil 7 übergehen. Die beiden Schenkel 6A und 6B des Bauteils 4 verlaufen annähernd parallel zueinander und sind derart ausgebildet, dass sie einerseits mindestens zwei, vorzugsweise vier, Füsse 8 und andererseits zwei Zungen 9A und 9B aufweisen. Die Zungen 9A und 9B sind gegenüber den Schenkeln 6 des "U" abgewinkelt. Der Winkel zwischen Zunge 9 und Schenkel 6 beträgt etwa 90°. Die beiden freien Enden der Zungen 9A und 9B, d.h. ihre Stirnseiten 10, liegen somit einander gegenüber und sind durch einen Luftspalt der Breite W voneinander getrennt. Die Leiterplatte 2 weist neben dem Magnetfeldsensor 3 angeordnete Schlitze 11 oder Bohrungen auf, in die die Füsse 8 des ferromagnetischen Bauteils 4 hineinsteckbar sind. Die Füsse 8 sind bevorzugt mit einem Anschlag 12 ausgebildet, der beim Hineinstecken der Füsse 8 in die Schlitze 11 der Leiterplatte 2 an der Oberfläche 5 der Leiterplatte 2 zum Anschlag kommt, so dass die Zungen 9 in einem definierten Abstand D parallel zur Oberfläche 5 der Leiterplatte 2 verlaufen. Der Abstand D ist mit Vorteil so bemessen, dass die Zungen 9 auf dem Gehäuse des Magnetfeldsensors 3 aufliegen, ohne übermässigen Druck auf das Gehäuse auszuüben, oder in geringem Abstand zum Magnetfeldsensor 3 angeordnet sind. Mit anderen Worten, der Abstand D entspricht in etwa der Höhe des Gehäuses des Magnetfeldsensors 3, wenn dieser auf der Leiterplatte 2 montiert ist. Das Mittelteil 7 und die Zungen 9A und 9B des ferromagnetischen Bauteils 4 begrenzen eine Öffnung 13, durch die das Kabel 1 hindurchgeführt ist.

Die Fig. 2 zeigt in Aufsicht das Blech, aus dem das ferromagnetische Bauteil 4 vorzugsweise gebildet ist, bevor es in die U-Form gebogen wurde. Die Linien 14 bezeichnen Biegekanten, d.h. die Kanten, um die die Zungen 9 gebogen werden, um sie gegenüber den Schenkeln 6 des "U" abzuwinkeln.

Die Fig. 3 zeigt den Magnetfeldsensor 3 der Fig. 1 in vergrösserter Darstellung. Dies ist ein bevorzugtes Ausführungsbeispiel des Magnetfeldsensors 3. Der Magnetfeldsensor 3 umfasst einen Halbleiterchip 15 mit mindestens einem in eine Oberfläche 16 integrierten, magnetfeldempfindlichen Sensorelement, im Beispiel einem Hallelement 17, und einem Elektronikschaltkreis für den Betrieb des mindestens einen Hallelements 17 und zwei auf der Oberfläche 16 des Halbleiterchips 15 angeordneten Magnetfeldkonzentratoren 18, die durch einen Luftspalt getrennt sind. Die Magnetfeldkonzentratoren 18 sind durch eine ferromagnetische Schicht gebildet, die auf den Halbleiterchip 15 aufgebracht wurde. Der Begriff Hallelement umfasst auch einen Cluster von Hallelementen. Das mindestens eine Hallelement 17 ist ein sogenanntes horizontales Hallelement, das empfindlich ist auf diejenige Komponente des Magnetfelds, die senkrecht zur Oberfläche 16 des Halbleiterchips 15 verläuft. Im Beispiel sind zwei horizontale Hallelemente vorhanden, die beidseitig des Luftspalts zwischen den Magnetfeldkonzentratoren 18 im Bereich deren Randes unterhalb der Magnetfeldkonzentratoren 18 angeordnet sind. Die Fig. 4 zeigt ein weiteres Ausführungsbeispiel des Magnetfeldsensors 3, bei dem das mindestens eine Hallelement 17 ein vertikales Hallelement ist, das empfindlich ist auf diejenige Komponente des Magnetfelds, die parallel zur Oberfläche in der als x-Richtung bezeichneten Richtung verläuft. Das mindestens eine vertikale Hallelement 17 ist etwa in der Mitte des Luftspalts zwischen den Magnetfeldkonzentratoren 18 angeordnet. Die Hallelemente 17 werden in beiden Fällen von Feldlinien des Magnetfelds durchflutet, die beim einen Magnetfeldkonzentrator 18 auf seiner Unterseite neben dem Luftspalt austreten und beim anderen Magnetfeldkonzentrator 18 auf seiner Unterseite neben dem Luftspalt eintreten. Anstelle von Hallelementen können auch andere magnetfeldempfindliche Sensoren verwendet werden, insbesondere magnetoresistive Sensoren, beispielsweise AMR (= anisotroper magnetoresistiver Effekt) oder GMR (= giant magnetoresistiver Effekt) Sensoren oder ein Fluxgate-Sensor. Ein AMR-Sensor besteht beispielsweise aus vier schmalen Streifen aus einer dünnen ferromagnetischen Schicht, die in Form einer Wheatstone-Brücke geschaltet sind. Ein besonders gut geeignetes ferromagnetisches Material ist Mu-Metall (engl.: permalloy). Mu-Metall ist eine weichmagnetische Nickel-Eisen-Legierung hoher magnetischer Permeabilität. Ein GMR-Sensor enthält nicht eine einzige ferromagnetische Schicht, sondern eine Schichtfolge aus sich abwechselnden ferromagnetischen und nichtmagnetischen dünnen Schichten mit einigen Nanometern Schichtdicke. Vorteilhaft ist, wenn sich der AMR-Sensor bzw. GMR-Sensor bzw. Fluxgate-Sensor über die ganze Breite des Luftspalts bis unter die Endbereiche der Magnetfeldkonzentratoren 18 erstreckt, so dass er mit deren Endbereichen überlappt.

Die Fig. 5 zeigt im Schnitt einen Magnetfeldsensor 3 mit einem magnetfeldempfindlichen Sensorelement 19, das zum Beispiel ein magnetoresistiver Sensor oder ein Fluxgate-Sensor ist. Die Länge der Zungen 9A, 9B des ferromagnetischen Bauteils 4 und die Breite des magnetfeldempfindlichen Sensorelements 19 sind mit Vorteil so aufeinander abgestimmt, dass die Endbereiche der Zungen 9A, 9B mit den magnetischen Schichten bzw. Kernen des Sensorelements 19 überlappen.

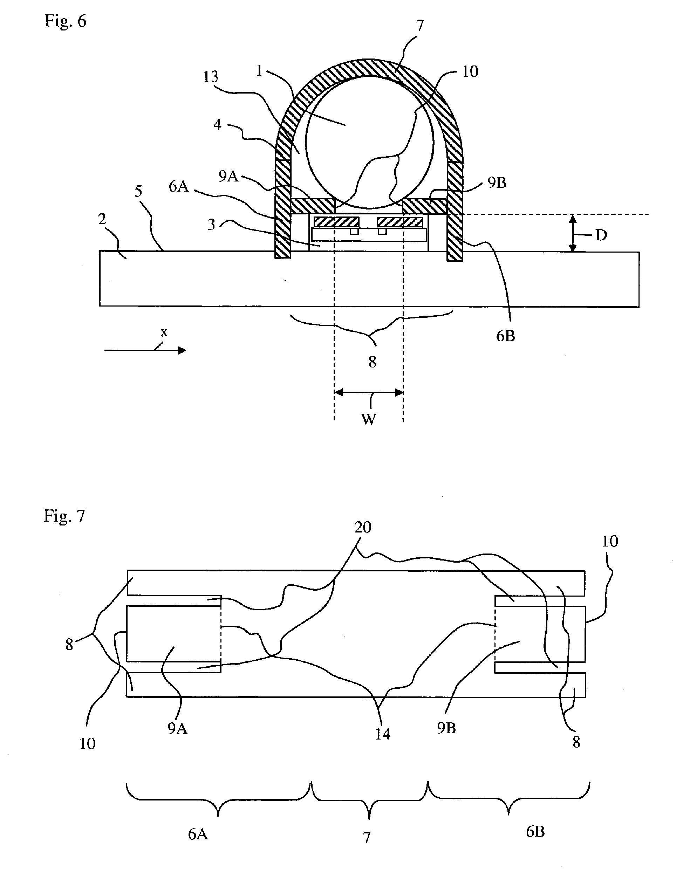

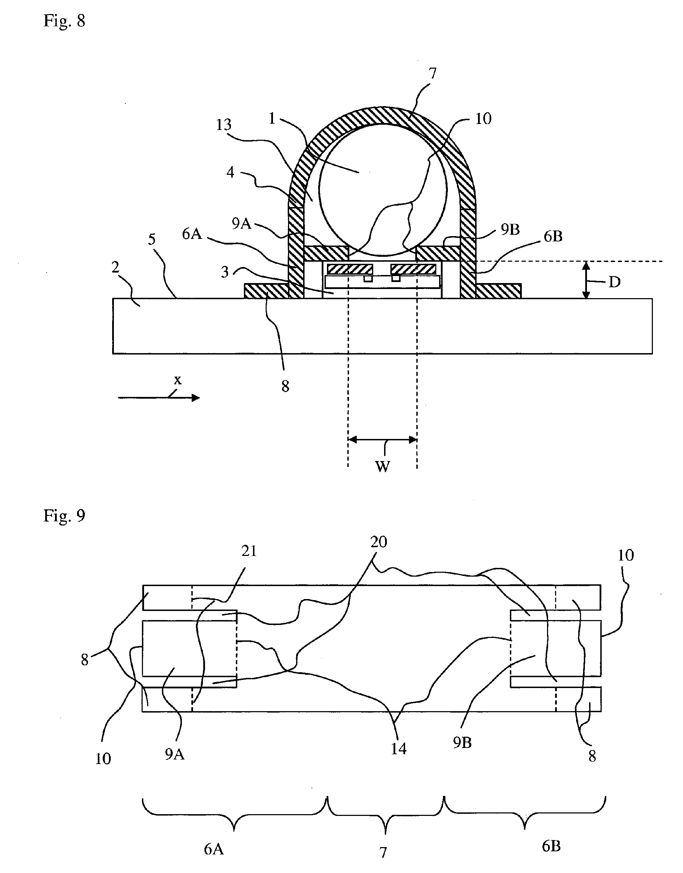

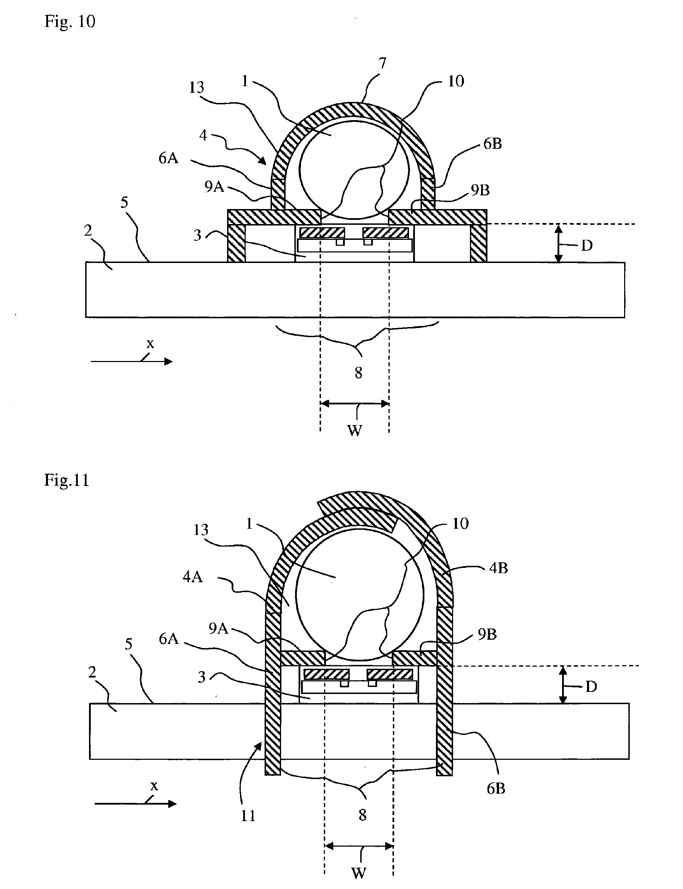

Die Fig. 6 bis 11 zeigen verschiedene Varianten des ersten Ausführungsbeispiels, die sich im wesentlichen durch die konkrete Ausgestaltung des ferromagnetischen Bauteils 4 unterscheiden. Bei der in der Fig. 6 gezeigten Variante ist der Ausgangspunkt des ferromagnetischen Bauteils 4 ein rechteckförmiges Blech, bei dem wie in der Fig. 7 dargestellt die Zungen 9 und die Füsse 8 durch Ausstanzen von vier parallelen Schlitzen 20 gebildet wurden. Die Füsse 8 sind entweder in die durchgehenden Schlitze 20 oder in nicht durchgehende Schlitze, d.h. Vertiefungen oder Sacklöcher, der Leiterplatte 2 hineingesteckt. Bei der in der Fig. 8 gezeigten Variante sind die Füsse 8 des ferromagnetischen Bauteils 4 gegenüber den Schenkeln 6 des "U" abgewinkelt, bei diesem Beispiel um 90°, und das ferromagnetische Bauteil 4 ist nicht in Schlitze der Leiterplatte 2 hineingesteckt, sondern auf der Oberfläche 5 der Leiterplatte 2 befestigt, beispielsweise durch Kleben oder Löten. In diesem Fall ist die Leiterplatte 2 mit Vorteil mit unmittelbar neben dem Magnetfeldsensor 3 angeordneten Positionierungselementen oder Positionierungsmarkierungen versehen, die bei der Montage eine präzise Ausrichtung des ferromagnetischen Bauteils 4 in Bezug auf den Magnetfeldsensor 3 gewährleisten. Die Fig. 9 zeigt in Aufsicht das als Ausgangspunkt des ferromagnetischen Bauteils 4 dienende Blech, wobei die Linien 21 weitere Biegekanten bezeichnen, um die die Füsse 8 gebogen werden, um die zur Oberfläche 5 der Leiterplatte 2 parallele Ausrichtung der Füsse 8 zu erhalten. Bei der in der Fig. 10 gezeigten Variante sind sowohl die Zungen 9 als auch die Füsse 8 gegenüber den Schenkeln 6 des "U" abgewinkelt, jedoch in umgekehrter Richtung, und die Füsse 8 sind nochmals abgewinkelt, so dass sich die in der Fig. 10 im Schnitt dargestellte Form des ferromagnetischen Bauteils 4 ergibt. Das erste Ausführungsbeispiel und die gezeigten Varianten können in beliebiger Form kombiniert werden, um die Form des ferromagnetischen Bauteils 4 optimal an Grösse bzw. Durchmesser des Kabels 1 anzupassen und eine einfache und stabile Art der Befestigung des ferromagnetischen Bauteils 4 an der Leiterplatte 2 zu erreichen. Die Fig. 11 zeigt eine Variante, bei der das ferromagnetische Bauteil 4 aus zwei Komponenten besteht, nämlich einer Komponente 4A und einer Komponente 4B. Die das Mittelteil 7 des ferromagnetischen Bauteils 4 bildenden Enden der beiden Komponenten 4A und 4B überlappen miteinander, sie können aber auch miteinander verzahnt sein. Diese zweiteilige Ausgestaltung ermöglicht es, das ferromagnetische Bauteil 4 an einem Kabel 1 zu montieren, das bereits fest verkabelt ist, ohne dass das Kabel 1 gelöst und durch die Öffnung 13 des ferromagnetischen Bauteils 4 hindurchgeführt werden muss.

Das ferromagnetische Bauteil 4 ist bei den gezeigten Ausführungsbeispielen aus einem Stück Blech bzw. einem Laminat aus Blechen gebildet und durch Ausstanzen und Biegen in seine Form gebracht worden. Das ferromagnetische Bauteil 4 kann aber auch bei allen Ausführungsbeispielen aus Ferrit bestehen und durch einen Sinterprozess hergestellt werden.

Das ferromagnetische Bauteil 4 beinhaltet zwei magnetische Kreise, nämlich einen ersten Magnetkreis, der im wesentlichen das Kabel 1 umschliesst und die Zungen 9 umfasst, und einen zweiten Magnetkreis, der die Füsse 8 umfasst, wobei das Mittelteil 7 und daran anschliessende Teile der Schenkel 6 zu beiden Magnetkreisen gehören. Das ferromagnetische Bauteil 4 und die Magnetfeldkonzentratoren 18 bilden nämlich den ersten magnetischen Kreis mit dem Luftspalt, indem das magnetfeldempfindliche Sensorelement (wie oben beschrieben zum Beispiel ein Hallelement, AMR-Sensor, GMR-Sensor, Fluxgate-Sensor) angeordnet ist. Die Empfindlichkeit der Vorrichtung in Bezug auf den durch das Kabel 1 fliessenden Strom hängt ab von der Ausgestaltung dieses ersten Magnetkreises, insbesondere von der Geometrie und Grösse seiner Luftspalte. Die Empfindlichkeit der Vorrichtung kann verringert werden, entweder durch Vergrösserung des vertikalen Abstands zwischen den Zungen 9 des ferromagnetischen Bauteils 4 und dem Magnetfeldsensor 3 (insbesondere den Magnetfeldkonzentratoren 18) oder dadurch, dass die Zungen 9 des ferromagnetischen Bauteils 4 und der Magnetfeldsensor 3 nicht überlappen. D.h. gegebenenfalls, dass der Abstand W zwischen den Stirnseiten 10 der Zungen 9A und 9B grösser ist als die Gesamtlänge der Magnetfeldkonzentratoren 18 auf dem Halbleiterchip 15, so dass die Zungen 9 und die Magnetfeldkonzentratoren 18 jeweils durch einen seitlichen Luftspalt getrennt sind. Auf diese Weise kann die Empfindlichkeit der Vorrichtung an den maximal zu messenden Strom angepasst werden.

Äussere magnetische Störfelder treten bei den Füssen 8 auf der einen Seite in das ferromagnetische Bauteil 4 ein, werden durch das Mittelteil 7 hindurch geleitet und treten bei den Füssen 8 auf der anderen Seite wieder aus. Äussere magnetische Störfelder werden somit um den Magnetfeldsensor 3 herum geleitet. Über die Ausrichtung der Enden der Füsse 8, d.h. ob sie senkrecht (wie z.B. in der Fig. 1 dargestellt) oder parallel zur Oberfläche 5 der Leiterplatte 2 (wie z.B. in der Fig. 8 dargestellt) ausgerichtet sind, und ihre Länge oder auch Breite lässt sich der Grad der Abschirmung des ferromagnetischen Bauteils 4 gegenüber äusseren magnetischen Störfeldern massgeblich steuern.

Wenn die Füsse 8 parallel zur Oberfläche 5 der Leiterplatte 2 verlaufen und das ferromagnetische Bauteil 4 auf die Leiterplatte 2 geklebt oder gelötet wird, dann ist es vorteilhaft, die Enden der Schenkel 6 mit weiteren (nicht dargestellten) Füssen auszubilden, die in die Schlitze 11, Bohrungen oder Vertiefungen der Leiterplatte 2 hineinsteckbar sind. (Mit anderen Worten, das ferromagnetische Bauteil 4 enthält dann sowohl die abgewinkelten Füsse der Fig. 8 als auch die Füsse der Fig. 1.) Die Schlitze 11 dienen als Positionierungselemente, die zusammen mit den weiteren Füssen eine präzise Ausrichtung des ferromagnetischen Bauteils 4 in Bezug auf den Magnetfeldsensor 3 gewährleisten.

Die Leiterplatte 2 kann so klein sein, dass sie zwischen den Füssen 8 Platz hat. In diesem Fall sind die Füsse 8 so ausgebildet, dass sie direkt am Rand der Leiterplatte 2 befestigt werden können. Der Rand der Leiterplatte 2 kann beispielsweise Ausnehmungen enthalten, in die die Füsse 8 passen. Bei einer Ausführungsart klemmen die Füsse 8 die Leiterplatte 2 ein.

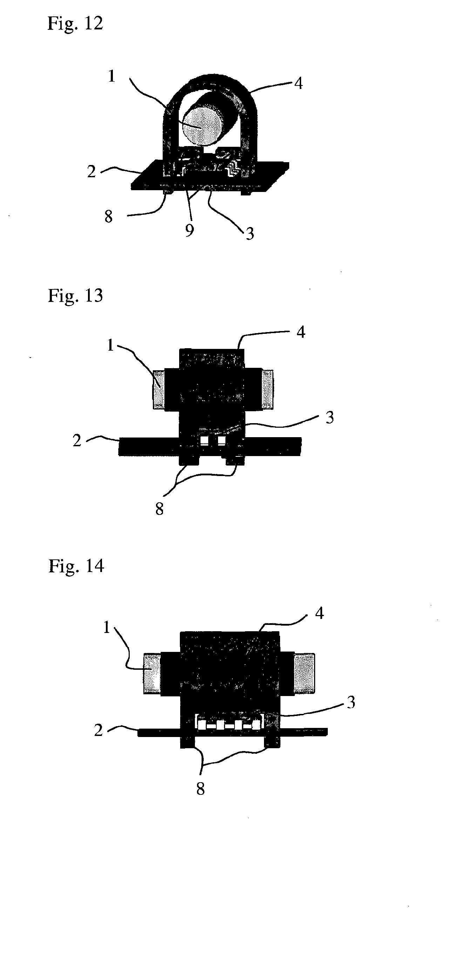

Die Fig. 12 zeigt das erste Ausführungsbeispiel in perspektivischer Ansicht, wobei der Durchmesser des Kabels 1 aus Gründen der zeichnerischen Klarheit verkleinert ist. Mit Vorteil ist die Größe des ferromagnetischen Bauteils 4 so bemessen, dass das Mittelteil 7 und die Zungen 9 am Kabel 1 anliegen. Der Magnetfeldsensor 3 ist in ein Standardgehäuse mit seitlich herausragenden Füssen verpackt.

Die Fig. 13 zeigt in seitlicher Ansicht eine erste Variante dieses Ausführungsbeispiels, bei dem die Füsse des Magnetfeldsensors 3 innerhalb des Bereichs der Füsse 8 des ferromagnetischen Bauteils 4 Platz finden. Die Fig. 14 zeigt in seitlicher Ansicht eine zweite Variante dieses Ausführungsbeispiels, bei dem das ferromagnetische Bauteil 4 schmaler als der Magnetfeldsensor 3 ist und deshalb länger ausgebildet wurde, so dass die Füsse des Magnetfeldsensors 3 zwischen zwei Füssen des ferromagnetischen Bauteils 4 Platz finden.

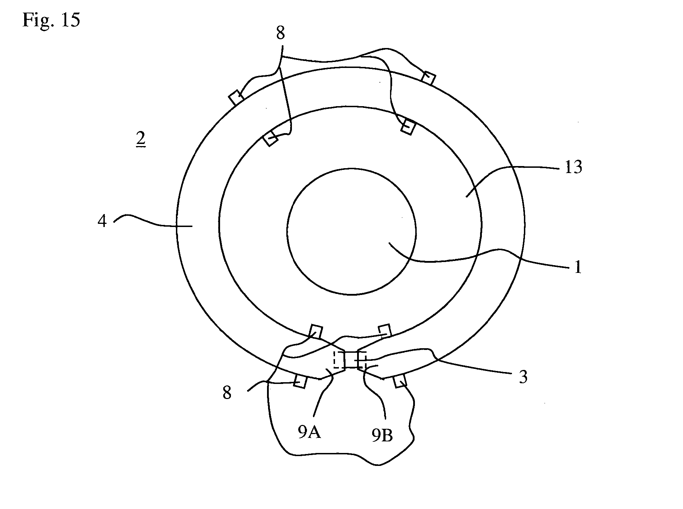

Die Fig. 15 zeigt im Schnitt ein zweites Ausführungsbeispiel einer erfindungsgemässen Vorrichtung zur Messung eines durch ein elektrisches Kabel 1 fliessenden Stroms. Bei diesem Ausführungsbeispiel ist das ferromagnetische Bauteil 4 aus einem im wesentlichen ringförmigen Stück Blech gebildet, das zwei einander gegenüberliegende, durch einen Luftspalt getrennte Enden hat, d.h. der Ring ist nicht geschlossen. Diese Enden sind als Zungen 9A und 9B ausgebildet, wobei deren Stirnseiten 10 einander gegenüberliegen und durch den Luftspalt getrennt sind. Das Blech ist mit Füssen 8 ausgebildet, die gegenüber der vom Ring aufgespannten Ebene um etwa 90° abgewinkelt sind. Mindestens einige der Füsse 8 sind unmittelbar bei den Zungen 9A und 9B angeordnet, so dass nach der Montage des ferromagnetischen Bauteils 4 auf der Leiterplatte 2 die Lage der Zungen 9A und 9B in Bezug auf die Leiterplatte 2 bzw. den Magnetfeldsensor 3 einerseits gut definiert und andererseits langzeitstabil ist. Der Innendurchmesser der Öffnung 13 des Rings entspricht etwa dem Durchmesser des Kabels 1. Bei diesem Ausführungsbeispiel hat auch die Leiterplatte 2 ein Loch, das mit der vom ringförmigen ferromagnetischen Bauteil 4 umschlossenen Öffnung 13 einen Durchgang für das Kabel 1 bildet.

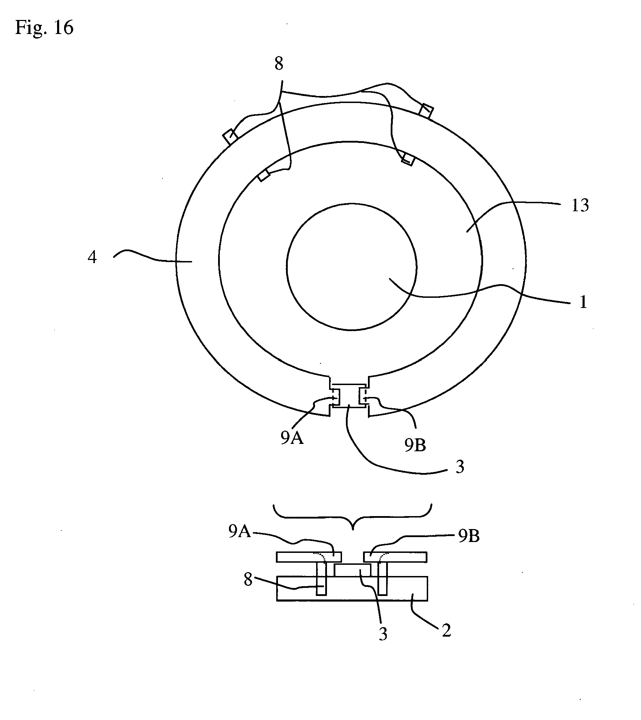

Die Fig. 16 zeigt eine Variante des zweiten Ausführungsbeispiels, bei der die Füsse 8 unmittelbar neben den Zungen 9 angeordnet sind. Die Biegekanten der Füsse 8 verlaufen hier parallel zu den Stirnseiten der Zungen 9A und 9B. Der Bereich der Zungen 9A und 9B ist unterhalb der geschweiften Klammer im Schnitt dargestellt.

Die erfindungsgemässe Vorrichtung hat mehrere Vorteile:
- Der magnetische Widerstand des durch das ferromagnetische Bauteil 4 und den Magnetfeldsensor 3 gebildeten Magnetkreises ist sehr gering, da er beim Einsatz eines Hallsensors nur einen Luftspalt von etwa 30 µm aufweist. Bei der Verwendung eines magnetoresistiven Sensors oder Fluxgate Sensors als Magnetfeldsensor ist der magnetische Widerstand noch geringer, da diese Sensortypen selbst ferromagnetische Schichten umfassen, so dass der effektive Luftspalt des Magnetkreises noch kleiner wird oder verschwindet. Daraus resultiert bei Bedarf eine hohe Empfindlichkeit der Vorrichtung.
- Das ferromagnetische Bauteil 4 ist einerseits ein effizienter analoger Verstärker des zu messenden Magnetfeldes und andererseits eine effiziente Abschirmung gegen äussere magnetische Störfelder.
- Der Materialaufwand ist markant geringer als im Stand der Technik.
- Die Montage an einem Kabel ist sehr einfach.
- Die Vorrichtung ist besonders geeignet für sogenannte "smart grid" und "smart monitoring" Anwendungen.
- Um stabile magnetische Verhältnisse auszubilden, muss das ferromagnetische Bauteil 4, nachdem das Blech in seine endgültige Form gebogen wurde, insbesondere wenn es aus einer Legierung wie Mumetall besteht, geglüht werden und darf dann mechanisch nicht mehr verändert werden, da sonst Hystereseeffekte entstehen können. Ausgenommen sind jedoch die Füsse 8, diese dürfen auch nach dem Glühen mechanisch noch bearbeitet werden, insbesondere bei der Montage am Kabel 1, da die Füsse 8 zwar Bestandteil des ferromagnetischen Bauteils 4, jedoch nicht in seine magnetische Funktion der Verstärkung des zu erfassenden Magnetfelds involviert sind.

## Patentansprüche

1. Vorrichtung zur Messung eines durch ein elektrisches Kabel (1) fliessenden Stroms, umfassend eine Leiterplatte (2),
einen Magnetfeldsensor (3), und
ein ferromagnetisches Bauteil (4) aus Blech, das U-förmig gebogen ist und ein Mittelteil (7) und zwei Schenkel (6A, 6B) aufweist,
wobei der Magnetfeldsensor (3) und das ferromagnetische Bauteil (4) auf einer Oberfläche (5) der Leiterplatte (2) montiert sind,
wobei der Magnetfeldsensor (3) empfindlich ist auf ein parallel zur Oberfläche (5) der Leiterplatte (2) verlaufendes Magnetfeld,
wobei das ferromagnetische Bauteil (4) weiter zwei Zungen (9A, 9B), deren Stirnseiten (10) einander gegenüberliegen und durch einen Luftspalt getrennt sind, und mindestens zwei Füsse (8) aufweist, wobei die Zungen (9A, 9B) aus den Schenkeln (6A, 6B) ausgestanzt und gegenüber den Schenkeln (6A, 6B) abgebogen und somit abgewinkelt sind, und wobei die Füsse (8) auf der Leiterplatte (2) befestigt sind,
wobei die Zungen (9A, 9B) des ferromagnetischen Bauteils (4) parallel zur Oberfläche (5) der Leiterplatte (2) verlaufen und entweder auf dem Magnetfeldsensor (3) aufliegen oder im Abstand zum Magnetfeldsensor (3) oberhalb des Magnetfeldsensors (3) angeordnet sind, und
wobei das Mittelteil (7) und die Zungen (9A, 9B) eine Öffnung (13) umschliessen, durch die das Kabel (1) hindurchführbar ist.

2. Vorrichtung nach Anspruch 1, **dadurch gekennzeichnet, dass** das ferromagnetische Bauteil (4) aus zwei Komponenten (4A, 4B) besteht, damit die Vorrichtung an einem fest montierten Kabel montierbar ist.

3. Vorrichtung nach Anspruch 1 oder 2, **dadurch gekennzeichnet, dass** die Leiterplatte (2) Schlitze (11) oder Bohrungen oder Vertiefungen aufweist, in die die Füsse (8) des ferromagnetischen Bauteils (4) hineinsteckbar sind.

4. Vorrichtung nach Anspruch 1 oder 2, **dadurch gekennzeichnet, dass** die Enden der Füsse (8) des ferromagnetischen Bauteils (4) parallel zur Oberfläche (5) der Leiterplatte (2) verlaufen und auf die Leiterplatte (2) geklebt oder gelötet sind.

5. Vorrichtung nach Anspruch 4, **dadurch gekennzeichnet, dass** die Leiterplatte (2) Schlitze (11) oder Bohrungen oder Vertiefungen aufweist und dass das ferromagnetische Bauteil (4) weitere Füsse umfasst, die in die Schlitze (11) bzw. Bohrungen bzw. Vertiefungen hineinsteckbar sind.

6. Vorrichtung nach einem der Ansprüche 1 bis 5, **dadurch gekennzeichnet, dass** der Magnetfeldsensor (3) einen Halbleiterchip (15) mit mindestens einem integrierten Hallelement (15) und zwei auf dem Halbleiterchip (15) angeordnete Magnetfeldkonzentratoren (18) aufweist, die durch einen Luftspalt getrennt sind, und dass das mindestens eine Hallelement (17) im Bereich dieses Luftspalts angeordnet ist.

7. Vorrichtung nach Anspruch 6, **dadurch gekennzeichnet, dass** die Zungen (9A, 9B) des ferromagnetischen Bauteils (4) und die Magnetfeldkonzentratoren (18) zumindest teilweise überlappen.

8. Vorrichtung nach einem der Ansprüche 1 bis 5, **dadurch gekennzeichnet, dass** der Magnetfeldsensor (3) einen magnetoresistiven Sensor oder einen Fluxgate Sensor (19) umfasst.

## Claims

1. Device for measuring a current flowing through an electric cable (1), comprising:
a printed circuit board (2),
a magnetic field sensor (3), and
a ferromagnetic component (4) of sheet metal which is bent in a U-shaped manner and comprises a middle part (7) and two legs (6A, 6B),
wherein the magnetic field sensor (3) and the ferromagnetic component (4) are mounted on a surface (5) of the printed circuit board (2),
wherein the magnetic field sensor (3) is sensitive to a magnetic field extending parallel to the surface (5) of the printed circuit board (2),
wherein the ferromagnetic component further comprises two tongues (9A, 9B), whose front faces (10) are disposed opposite of each other and separated by an air gap, and at least two feet (8), wherein the tongues (9A, 9B) are punched out from the legs (6A, 6B) and bent off relative to the legs (6A, 6B) and therefore form an angle with the legs (6A, 6B),
wherein the tongues (9A, 9B) of the ferromagnetic component (4) extend parallel to the surface (5) of the printed circuit board (2), and either rest on the magnetic field sensor (3) or are arranged at a distance from the magnetic field sensor (3) above the magnetic field sensor (3), and
wherein the middle part (7) and the tongues (9A, 9B) enclose an opening (13) through which the cable is guidable.

2. Device according to claim 1, **characterized in that** the ferromagnetic component (4) consists of two components (4A, 4B), so that the device can be mounted on a fixedly mounted cable.

3. Device according to claim 1 or 2, **characterized in that** the printed circuit board (2) comprises slots (11) or boreholes or depressions, into which the feet (8) of the ferromagnetic component (4) are insertable.

4. Device according to claim 1 or 2, **characterized in that** the ends of the feet (8) of the ferromagnetic component (4) extend parallel to the surface (5) of the printed circuit board (2), and are glued or soldered to the printed circuit board (2).

5. Device according to claim 5, **characterized in that** the printed circuit board (2) comprises slots (11) or boreholes or depressions and that the ferromagnetic component (4) comprises further feet which are insertable into the slots (11) or boreholes or depressions.

6. Device according to any of claims 1 to 5, **characterized in that** the magnetic field sensor (3) comprises a semiconductor chip (15) with at least one integrated Hall element (15) and two magnetic field concentrators (18) which are arranged on the semiconductor chip (15) and are separated by an air gap, and that the at least one Hall element (17) is arranged in the region of said air gap.

7. Device according to claim 6, **characterized in that** the tongues (9A, 9B) of the ferromagnetic component (4) and the magnetic field concentrators (18) overlap one another at least in part.

8. Device according to any of claims 1 to 5, **characterized in that** the magnetic field sensor (3) comprises a magnetoresistive sensor or a fluxgate sensor (19).

## Revendications

1. Dispositif pour la mesure d'un courant passant dans un câble électrique (1), comprenant
une carte de circuits imprimés (2),
un capteur de champ magnétique (3) et
un élément ferromagnétique (4) en tôle, plié en forme de U et présentant une partie intermédiaire (7) et deux bras (6A, 6B),
dans lequel le capteur de champ magnétique (3) et l'élément ferromagnétique (4) sont montés sur une surface (5) de la carte de circuits imprimés (2),
dans lequel le capteur de champ magnétique (3) est sensible à un champ magnétique parallèle à la surface (5) de la carte de circuits imprimés (2),
dans lequel l'élément ferromagnétique (4) présente en outre deux languettes (9A, 9B), dont les faces frontales (10) se font face et sont séparées par un entrefer, ainsi qu'au moins deux pieds (8), les languettes (9A, 9B) étant découpées dans les bras (6A, 6B) et pliées par rapport aux bras (6A, 6B), formant ainsi un angle par rapport aux bras (6A, 6B), et les pieds (8) étant fixés sur la carte de circuits imprimés (2),
dans lequel les languettes (9A, 9B) de l'élément ferromagnétique (4) sont parallèles à la surface (5) de la carte de circuits imprimés (2) et soit reposent sur le capteur de champ magnétique (3), soit sont disposées à distance du capteur de champ magnétique (3) au-dessus du capteur de champ magnétique (3), et
dans lequel la partie intermédiaire (7) et les languettes (9A, 9B) entourent une ouverture (13) à travers laquelle le câble (1) peut être passé.

2. Dispositif selon la revendication 1, **caractérisé en ce que** l'élément ferromagnétique (4) se compose de deux composants (4A, 4B) afin que le dispositif puisse être assemblé autour d'un câble fixe.

3. Dispositif selon la revendication 1 ou 2, **caractérisé en ce que** la carte de circuits imprimés (2) présente des fentes (11) ou des perçages ou des creux dans lesquels les pieds (8) de l'élément ferromagnétique (4) peuvent être insérés.

4. Dispositif selon la revendication 1 ou 2, **caractérisé en ce que** les extrémités des pieds (8) de l'élément ferromagnétique (4) sont parallèles à la surface (5) de la carte de circuits imprimés (2) et sont collées ou brasées sur la carte de circuits imprimés (2).

5. Dispositif selon la revendication 4, **caractérisé en ce que** la carte de circuits imprimés (2) présente des fentes (11) ou des perçages ou des creux et **en ce que** l'élément ferromagnétique (4) comprend d'autres pieds qui peuvent être insérés dans les fentes (11) ou les perçages ou les creux.

6. Dispositif selon l'une des revendications 1 à 5, **caractérisé en ce que** le capteur de champ magnétique (3) présente une puce de semi-conducteurs (15) avec au moins un élément à effet Hall (15) intégré et deux concentrateurs de champ magnétique (18) disposés sur la puce de semi-conducteurs (15) qui sont séparés par un entrefer, et **en ce que** l'au moins un élément à effet Hall (17) soit disposé dans la région de cet entrefer.

7. Dispositif selon la revendication 6, **caractérisé en ce que** les languettes (9A, 9B) de l'élément ferromagnétique (4) et les concentrateurs de champ magnétique (18) se chevauchent au moins partiellement.

8. Dispositif selon l'une des revendications 1 à 5, **caractérisé en ce que** le capteur de champ magnétique (3) comprend un capteur magnétorésistif ou un capteur fluxgate (19).
